# EUROPEAN PATENT APPLICATION

(11) **EP 4 538 895 A1**
(43) Date of publication of application: **16.04.2025**
(21) Application number: 23203217.7
(22) Date of filing: 12.10.2023
(51) Int. Cl.: G06F 11/36, G06F 30/20, G01M 17/00

(54) **METHOD FOR ENABLING VALIDATION OF TESTING ENVIRONMENTS FOR TESTING A CONTROL SYSTEM OF AN AUTONOMOUS VEHICLE, DATA PROCESSING APPARATUS, COMPUTER PROGRAM, AND COMPUTERREADABLE STORAGE MEDIUM**

(71) Applicant: Volvo Car Corporation, 405 31 Göteborg (SE)
(72) Inventor: FEI, Zhennan, 40531 Göteborg (SE); ANDERSSON, Mikael, 40531 Göteborg (SE); TINGBERG, Andreas, 40531 Göteborg (SE)
(74) Representative: Maiwald GmbH

(57) **Abstract**

The disclosure relates to a method for enabling validation of a first testing environment configured for testing a control system (22) of an autonomous vehicle (20) against a second testing environment configured for testing the control system (22) of the autonomous vehicle (20). Each of the first testing environment and the second testing environment comprises the autonomous vehicle (20) or a representation of the autonomous vehicle (20) and an obstacle (26) or a representation of the obstacle (26). Both the first testing environment and the second testing environment are associated with the same real-world scenario. The method comprises receiving first data indicative of a test of the control system (22) in the first testing environment and receiving second data indicative of a test of the control system (22) in the second testing environment. The first data and the second data are coordinated and, subsequently, a correlation of at least one element of the first data and at least one element of the second data is determined. Moreover, a data processing apparatus, a computer program, and a computer-readable storage medium are presented.

## Description

### TECHNICAL FIELD

The present disclosure relates to a method for enabling validation of a first testing environment configured for testing a control system of an autonomous vehicle against a second testing environment configured for testing the control system of the autonomous vehicle.

Additionally, the present disclosure is directed to a data processing apparatus, a computer program, and a computer-readable storage medium.

### BACKGROUND ART

In order to ensure reliable functioning of a control system for an autonomous vehicle, e.g. an autonomous driving system or an advanced driver assistances system (ADAS), such a control system needs to be tested. It is only after that, that a control system for an autonomous vehicle may be delivered to a customer or user of the autonomous vehicle. In this context it is known to test a control system on a test track. It is additionally known to use so-called virtual testing or simulation. This means that the testing is done in a virtual world using a computer system. Among other things this is due to the fact that it may be impossible to test the control system in all relevant situations on the test track. For example, some relevant situations may be too dangerous for being tested on the test track.

However, it is the nature of testing environments that they differ from the real world. This leads to the necessity to keep an eye on the validity of conclusions drawn from testing environments when applied to the real world.

### SUMMARY

Consequently, the problem to be solved by the present disclosure is to facilitate the validation of testing environments.

The problem is at least partially solved or alleviated by the subject matter of the independent claims of the present disclosure, wherein further examples are incorporated in the dependent claims.

According to a first aspect, there is provided a method for enabling validation of a first testing environment configured for testing a control system of an autonomous vehicle against a second testing environment configured for testing the control system of the autonomous vehicle. Each of the first testing environment and the second testing environment comprises the autonomous vehicle or a representation of the autonomous vehicle and an obstacle or a representation of the obstacle. Moreover, both the first testing environment and the second testing environment are associated with the same real-world scenario. The method comprises:
- receiving first data indicative of a test of the control system in the first testing environment,
- receiving second data indicative of a test of the control system in the second testing environment,
- coordinating the first data and the second data, and
- subsequently determining a correlation of at least one element of the first data and at least one element of the second data, thereby enabling validation.

Using a first testing environment and a second testing environment for testing the control system has the advantage that testing activities may be distributed over the first testing environment and the second testing environment. This means that a first portion of the necessary tests may be performed using the first testing environment and a second portion of the necessary tests may be performed using the second testing environment. Using this approach, an appropriate testing environment may be used for each of the tests to be performed. For example, potentially dangerous tests may be performed using a virtual testing environment. The method according to the present disclosure enables validation of the first testing environment against the second testing environment. This means that the method according to the present disclosure allows to determine whether both the first testing environment and the second testing environment are associated with the real-world scenario in a sufficiently close manner. According to an example, the method according to the present disclosure allows to determine whether both the first testing environment and the second testing environment replicate relevant aspects of the real-world scenario in a sufficiently similar manner. In this context, it is understood that it is not necessary to consider all aspects of a real-world scenario in a testing environment. Depending on the motivation to perform a test, it may be sufficient to consider only one or some of the aspects of the real-world scenario in the testing environment. In case the first testing environment and the second testing environment are found to be associated with the real-world scenario in a sufficiently close manner, e.g. replicate the real-world scenario in a sufficiently similar manner, test results obtained using the first testing environment and the second testing environment, i.e. the first data and the second data, may be considered to complement one another. In more detail, the first data and the second data are coordinated when executing the present method. This ensures that the first data and the second data describe the same or similar effects occurring in the first testing environment and the second testing environment respectively. In an example, the first data and the second data are synchronized, e.g. time-synchronized. In this case, synchronizing the first data and the second data ensures that elements of the first data and the second data which relate to the same point in time are associated with one another. In another example, the first data and the second data are event-synchronized. In this case, synchronizing the first data and the second data ensures that elements of the first data and the second data which relate to the same event are associated with one another. It is only after the coordination that a correlation of at least one element of the first data and at least one element of the second data is determined. This means that a degree is determined to which the at least one element of the first data and the at least one element of the second data are related. This enables validation since the determined correlation may be compared to a correlation threshold. The correlation threshold may define a sufficient degree of relatedness between the first data and the second data. This means that in a case in which the correlation is higher than the correlation threshold, the first testing environment and the second testing environment may be found to be associated with the real-world scenario in a sufficiently close manner, e.g. replicate the real-world scenario in a sufficiently similar manner. In a case in which the correlation is lower than the correlation threshold, the first testing environment and the second testing environment may be found not to be associated with the real-world scenario in a sufficiently close manner. Thus, only in the first case, the first data and the second data may be used in a complementary manner.

In the context of the present disclosure, the first data and the second data may be designated as drive logs.

In the context of the present disclosure, the control system of the autonomous vehicle may be an autonomous driving system (ADS) or an advanced driver assistances system (ADAS). The control system may comprise hardware components and/or software components.

Moreover, in the context of the present disclosure, the obstacle may generally be any object that affects a traveling path of the autonomous vehicle. In an example, the obstacle is another vehicle.

Furthermore, the real-world scenario may relate to any scenario in which the autonomous vehicle may be and in which the control system of the autonomous vehicle may be used. According to an example, the real-world scenario is a so-called cut-in scenario. In this scenario, the autonomous vehicle is driving along a lane of a road and another vehicle is entering this lane in front of the autonomous vehicle. In this scenario, the other vehicle is considered to be the obstacle and the autonomous vehicle needs to react to the other vehicle entering the lane. According to another example, the real-world scenario is a so-called lane-leave or cut-out scenario. In this scenario, the autonomous vehicle is traveling along a lane of a road, wherein, at the same time, the autonomous vehicle is traveling behind another vehicle. The other vehicle may detect an obstacle on the lane and made leave the lane. Consequently, the autonomous vehicle also needs to react to this obstacle which is only detectable for the autonomous vehicle because the other vehicle has left the lane.

It is noted that the first testing environment and the second testing environment have to be chosen such that both the first testing environment and the second testing environment are able to be associated with the real-world scenario to be tested in the relevant aspects, e.g. replicate the relevant aspects of the real-world scenario to be tested. Only then, the first testing environment at the second testing environment are able to at least theoretically provide first data and second data which are complementary. This may become clear when considering the following illustrative example. In a case in which the first testing environment is implemented on a test track and the second testing environment is implemented as a simulation, the size and geometry of the test track may lead to limitations of the maximum speed that the autonomous vehicle can reach. It is obvious that using different speeds in the first testing environment and in the second testing environment hinders comparability of the test results. In another example, the first testing environment again is implemented on a test track and the second testing environment is implemented as a simulation. If friction between the tires of the autonomous vehicle and the road surface is relevant for the real-world scenario, it is obvious that on the test track, the friction may only be varied within practical limits, whereas in the simulation the friction can be chosen rather freely. Thus, the same or comparable friction may have to be used in order to make the test results comparable.

According to an example, at least one of the first testing environment and the second testing environment is of probabilistic nature. Additionally or alternatively, at least one of the first testing environment and the second testing environment is of deterministic nature. In this case, a testing environment of probabilistic nature is a testing environment that may only be described by statistical probabilities. This means that the testing results generated using this testing environment may vary. In contrast thereto, a testing environment of deterministic nature will provide the exact same testing results any time it is used. A testing environment implemented by a simulation may be of deterministic nature. However, a testing environment implemented by a simulation may as well be of probabilistic nature if probabilistic elements form part of the simulation. A testing environment implemented on a test track is an example of a testing environment of probabilistic nature. Thus, using the method according to the present disclosure, two testing environments of probabilistic nature, two testing environments of deterministic nature and testing environments of mixed natures, e.g. one of probabilistic nature and one of deterministic nature, may be used.

In an example, the method further comprises:
- modifying or confirming the first testing environment based on the second data, and/or
- modifying or confirming the second testing environment based on the first data.

In other words, the first testing environment may be modified or tuned such that its correspondency to the second data is enhanced. Alternatively or additionally, the second testing environment may be modified or tuned based on the first data such that it better corresponds to the first data. This procedure facilitates the generation of reliable test results, i.e. a reliable first data and reliable second data.

In an example, the method further comprises:
- obtaining at least one statistical characteristic of the first data,
- obtaining at least one statistical characteristic of the second data, and
- comparing the at least one statistical characteristic of the first data and the at least one statistical characteristic of the second data.

Based on the comparison of the at least one statistical characteristic of the first data and the at least one statistical characteristic of the second data, a similarity or difference between the first data and the second data may be determined. Based thereon, a similarity or difference between the first testing environment and the second testing environment may be determined. In a case in which the at least one statistical characteristic of the first data and the at least one statistical characteristic of the second data is the same or similar, i.e. differ by a predefined margin only, one may conclude that the first testing environment and the second testing environment are sufficiently similar at least in respect of the effect described by the statistical characteristics. In doing so, complementarity of the first data and the second data may be ensured.

In an example, the first data is indicative of one or more of
- a position over time of the autonomous vehicle or the representation of the autonomous vehicle,
- a position over time of the obstacle or the representation of the obstacle,
- a distance between the autonomous vehicle or the representation of the autonomous vehicle and the obstacle or the representation of the obstacle,
- a velocity of the autonomous vehicle or the representation of the autonomous vehicle or
- an acceleration of the autonomous vehicle or the representation of the autonomous vehicle.

Depending on the real-world scenario to which the first testing environment is associated, these indicators are well-suitable for evaluating a test of the control system. According to an example, the velocity is a longitudinal velocity and the acceleration is a longitudinal acceleration. According to another example, the velocity is a lateral velocity and the acceleration is a lateral acceleration. Of course, these examples may also be combined.

Alternatively or additionally, the second data is indicative of one or more of
- a position over time of the autonomous vehicle or the representation of the autonomous vehicle,
- a position over time of the obstacle or the representation of the obstacle,
- a distance between the autonomous vehicle or the representation of the autonomous vehicle and the obstacle or the representation of the obstacle,
- a velocity of the autonomous vehicle or the representation of the autonomous vehicle or
- an acceleration of the autonomous vehicle or the representation of the autonomous vehicle.

Depending on the real-world scenario to which the second testing environment is associated, these indicators are well-suitable for evaluating a test of the control system. According to an example, the velocity is a longitudinal velocity and the acceleration is a longitudinal acceleration. According to another example, the velocity is a lateral velocity and the acceleration is a lateral acceleration. Of course, these examples may also be combined.

According to an example, coordinating the first data and the second data comprises
- determining a first instance within the first data at which the autonomous vehicle or the representation of the autonomous vehicle reacts to the obstacle or the representation of the obstacle for the first time or at which the obstacle or the representation of the obstacle enters a lane or at which the obstacle or a representation of the obstacle leaves a lane,
- determining a second instance within the second data at which the autonomous vehicle or the representation of the autonomous vehicle reacts to the obstacle or to the representation of the obstacle for the first time or at which the obstacle or the representation of the obstacle enters a lane or at which the obstacle or the representation of the obstacle leaves a lane, and
- selecting a coordination point prior to the first instance and prior to the second instance.

In this context, the autonomous vehicle or the representation of the autonomous vehicle reacts to the obstacle or the representation of the obstacle if the autonomous vehicle or the representation of the autonomous vehicle changes a driving parameter such as speed or acceleration or steering angle. By selecting the coordination point prior to the first instance and prior to the second instance, it is ensured that, after coordination, the first data and the second data both fully describe the real-world scenario to which both the first testing environment and the second testing environment are associated. This increases the reliability of the determination of the correlation.

According to an example, coordinating the first data and the second data comprises synchronizing the first data and the second data. In this case, the coordination point may be a synchronization point.

According to a further example, the above-mentioned coordination, e.g. synchronization, may also be used in order to coordinate, e.g. synchronize, the outcomes of different test runs executed in the same testing environment, i.e. in the first testing environment or the second testing environment. In doing so, the outcomes of the different test runs are made comparable.

In an example, the coordination point, e.g. synchronization point, is selected at an instance at which the first data is substantially constant and at which the second data is substantially constant. In this context, the first data being substantially constant may be associated with a steady-state in the first testing environment. Similarly, the second data being substantially constant may be associated with a steady-state in the second testing environment. The selection of the coordination point, e.g. synchronization point, ensures that the first data and/or the second data fully describe the desired effects.

In an example, a coordination criteria relates to a distance between the autonomous vehicle or the representation of the autonomous vehicle and the obstacle or the representation of the obstacle. This means that the first data and the second data are coordinated, where the distance between the autonomous vehicle or the representation of the autonomous vehicle and the obstacle or the representation of the obstacle is the same in both the first testing environment and the second testing environment. This is computationally simple and leads to a reliable determination of the correlation between the first data and the second data. As has been mentioned before, the coordination may comprise a synchronization. In this case, the coordination criteria is a synchronization criteria.

According to an example, coordinating, e.g. synchronizing, the first data and the second data comprises backwards extrapolating the first data and the second data. This means that one goes back in time along the time series defined by the first data and the second data. This leads to a reliable coordination, e.g. synchronization, of the first data and the second data. According to a further example, extrapolation can be performed by calculating the integral from the velocity and timestamps in the in-vehicle logs, i.e. in the first data or second data.

In an example, determining a correlation comprises determining a linear correlation and/or determining root means squared errors. Both linear correlation and root mean square errors may be calculated in a computationally efficient manner. Moreover, both these measures of correlation are reliable indicators of a correlation between at least one element of the first event at least one element of the second data.

According to an example, determining a correlation comprises determining a correlation measure and comparing the correlation measure to a threshold. As has been mentioned before, the correlation measure may be root mean square errors and/or a linear correlation. The threshold is a correlation threshold which may delimit an interval of acceptable correlation measures with respect to an interval of non-acceptable correlation measures. Based thereon, one may determine whether the first data and the second data are sufficiently correlated or not.

In an example, the at least one element of the first data and the at least one element of the second data is indicative of one or more of
- a distance between the autonomous vehicle or the representation of the autonomous vehicle and the obstacle or the representation of the obstacle,
- a velocity of the autonomous vehicle or the representation of the autonomous vehicle or
- an acceleration of the autonomous vehicle or the representation of the autonomous vehicle.

These data may be determined in a simple and reliable manner in both the first testing environment and the second testing environment. Moreover, these indicators provide useful insights into the behavior of the autonomous vehicle which is influenced by the control system thereof. According to an example, the velocity may be a longitudinal velocity. Additionally or alternatively, the acceleration may be a longitudinal acceleration. According to another example, the velocity may be a lateral velocity. Additionally or alternatively, the acceleration may be a lateral acceleration. The afore-mentioned examples may also be combined.

The method may be at least partly computer-implemented, and may be implemented in software or in hardware, or in software and hardware. Further, the method may be carried out by computer program instructions running on means that provide data processing functions. The data processing means may be a suitable computing means, such as an electronic control module etc., which may also be a distributed computer system. The data processing means or the computer, respectively, may comprise one or more of a processor, a memory, a data interface, or the like.

According to a second aspect, there is provided a data processing apparatus comprising means for carrying out the method of the present disclosure. Using such a data processing apparatus allows to determine whether both the first testing environment and the second testing environment are associated with the real-world scenario in a sufficiently close manner, e.g. replicate the real-world scenario in a sufficiently similar manner. In this case, test results obtained using the first testing environment and the second testing environment may be considered to complement one another. This enables validation since the determined correlation may be compared to a correlation threshold. The correlation threshold may define a sufficient degree of relatedness between the first data and the second data. This means that in a case in which the correlation is higher than the correlation threshold, the first testing environment and the second testing environment may be found to be associated with the real-world scenario in a sufficiently close manner, e.g. replicate the real-world scenario in a sufficiently similar manner. In a case in which the correlation is lower than the correlation threshold, the first testing environment and the second testing environment may be found not to be associated with the real-world scenario in a sufficiently close manner, e.g. not to replicate the real-world scenario in a sufficiently similar manner. Thus, only in the first case, the first data and the second data may be used in a complementary manner.

According to a third aspect, there is provided a computer program comprising instructions which, when the computer program is executed by a computer, cause the computer to carry out the method of the present disclosure. Using such a computer program allows to determine whether both the first testing environment and the second testing environment are associated with the real-world scenario in a sufficiently close manner, e.g. replicate the real-world scenario in a sufficiently similar manner. In this case, test results obtained using the first testing environment and the second testing environment may be considered to complement one another. This enables validation since the determined correlation may be compared to a correlation threshold. The correlation threshold may define a sufficient degree of relatedness between the first data and the second data. This means that in a case in which the correlation is higher than the correlation threshold, the first testing environment and the second testing environment may be found to be associated with the real-world scenario in a sufficiently close manner, e.g. replicate the real-world scenario in a sufficiently similar manner. In a case in which the correlation is lower than the correlation threshold, the first testing environment and the second testing environment may be found not to be associated with the real-world scenario in a sufficiently close manner, e.g. not to replicate the real-world scenario in a sufficiently similar manner. Thus, only in the first case, the first data and the second data may be used in a complementary manner.

According to a fourth aspect, there is provided a computer-readable storage medium comprising instructions which, when executed by a computer, cause the computer to carry out the method of the present disclosure. Using such a computer-readable storage medium allows to determine whether both the first testing environment and the second testing environment are associated with the real-world scenario in a sufficiently close manner, e.g. replicate the real-world scenario in a sufficiently similar manner. In this case, test results obtained using the first testing environment and the second testing environment may be considered to complement one another. This enables validation since the determined correlation may be compared to a correlation threshold. The correlation threshold may define a sufficient degree of relatedness between the first data and the second data. This means that in a case in which the correlation is higher than the correlation threshold, the first testing environment and the second testing environment may be found to be associated with the real-world scenario in a sufficiently close manner, e.g. replicate the real-world scenario in a sufficiently similar manner. In a case in which the correlation is lower than the correlation threshold, the first testing environment and the second testing environment may be found not to be associated with the real-world scenario in a sufficiently close manner, e.g. not to replicate the real-world scenario in a sufficiently similar manner. Thus, only in the first case, the first data and the second data may be used in a complementary manner.

It should be noted that the above examples may be combined with each other irrespective of the aspect involved.

These and other aspects of the present disclosure will become apparent from and elucidated with reference to the examples described hereinafter.

### BRIEF DESCRIPTION OF DRAWINGS

Examples of the disclosure will be described in the following with reference to the following drawings.
- Figure 1: shows a data processing apparatus according to the present disclosure comprising a computer-readable storage medium according to the present disclosure and a computer program according to the present disclosure, wherein the data processing apparatus may execute a method for enabling validation according to the present disclosure,
- Figure 2: illustrates a first real-world scenario used in connection with the method for enabling validation,
- Figures 3 to 8: illustrate first data and second data used as input for the method for enabling validation,
- Figure 9: illustrates a second real-world scenario which may be used in connection with the method for enabling validation, and
- Figure 10: illustrates a third real-world scenario which may be used in connection with the method for enabling validation.

### DETAILED DESCRIPTION

The Figures are merely schematic representations and serve only to illustrate examples of the disclosure. Identical or equivalent elements are in principle provided with the same reference signs.

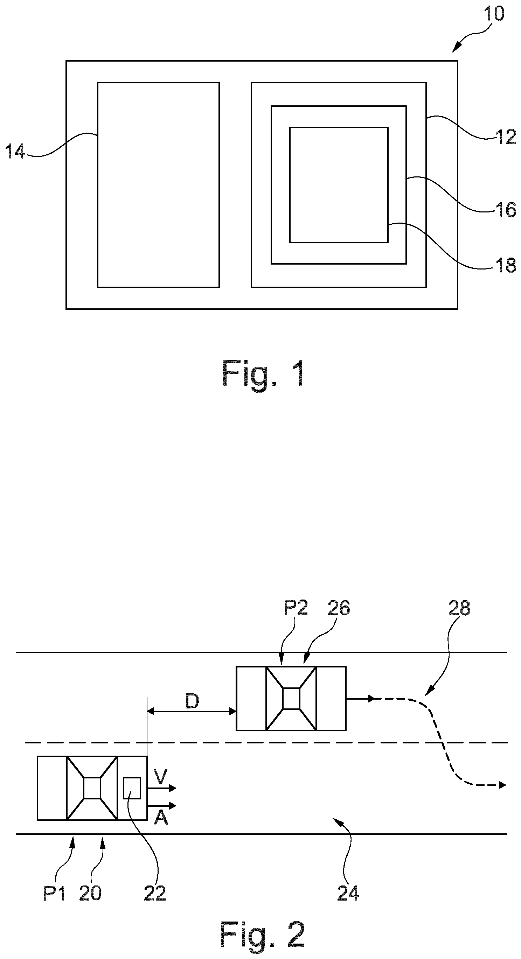

Figure 1 shows a data processing apparatus 10.

The data processing apparatus 10 comprises a data storage unit 12 and a data processing unit 14.

The data storage unit 12 comprises a computer-readable storage medium 16.

On the computer-readable storage medium 16, there is provided a computer program 18.

The computer program 18 and, thus, also the computer-readable storage medium 16 comprises instructions which, when executed by the data processing unit 14 or, more generally speaking, a computer, cause the data processing unit 14 or the computer to carry out a method for enabling validation of a first testing environment configured for testing a control system of an autonomous vehicle against a second testing environment configured for testing the control system of the autonomous vehicle.

Consequently, the data storage unit 12 and the data processing unit 14 form means 19 for carrying out the method for enabling validation of a first testing environment configured for testing a control system of an autonomous vehicle against a second testing environment configured for testing the control system of the autonomous vehicle.

This method will be explained in detail in the following. As has been mentioned before, the method enables validation of a first testing environment configured for testing a control system of an autonomous vehicle against a second testing environment configured for testing the control system of the autonomous vehicle.

In the present example, the first testing environment is a physical test track on which the autonomous vehicle may be operated. The second testing environment is a computer simulation. Thus, the second testing environment may also be called a virtual testing environment.

Since the test object is a control system of the autonomous vehicle and this control system comprises software, the second testing environment is a software in the loop simulation.

More generally speaking, the first testing environment is a testing environment of probabilistic nature. The second testing environment is a testing environment of deterministic nature.

Without limitation, the control system of the autonomous vehicle may be an automatic lane keeping system.

Moreover, in the present example, both the first testing environment and the second testing environment are associated with the same real-world scenario which is a so-called cut-in scenario. This means that both the first testing environment and the second testing environment replicate relevant aspects of this real-world scenario.

This means that in the present scenario, the autonomous vehicle 20 comprising the control system 22 to be tested travels on a first lane 24 and another vehicle 26, which may be designated as an obstacle, travels on a second lane 28 of the same road. The position over time of the autonomous vehicle 20 may be designated by P 1 and the position over time of the other vehicle 26 may be designated by P2. The autonomous vehicle 20 and the other vehicle 26 may have different initial speeds and may be located at a longitudinal distance D (cf. Figure 2). Furthermore, a velocity of the autonomous vehicle 20 is indicated by V and an acceleration of the autonomous vehicle is indicated by A.

At a certain longitudinal distance between the autonomous vehicle 20 and the other vehicle 26, the other vehicle 26 switches from the second lane 28 to the first lane 24 such that the other vehicle 26 is located in front of the autonomous vehicle 20. After the lane change, the other vehicle 26 decelerates.

In order to replicate the relevant aspects of the scenario, the first testing environment comprises the autonomous vehicle 20 and the other vehicle 26 or obstacle. It is noted that in such a case, the other vehicle 26 or obstacle may have a simplified form.

The second testing environment comprises a representation of the autonomous vehicle 20 and a representation of the other vehicle 26 or obstacle.

It is noted that the cut-in scenario is just an example. It is also possible to use the method for enabling validation of a first testing environment configured for testing a control system of an autonomous vehicle against a second testing environment in connection with other scenarios as will be explained further below.

Now, a number of test runs may be executed using the first testing environment, i.e. the physical test track. In the present example, five test runs are executed in the first testing environment.

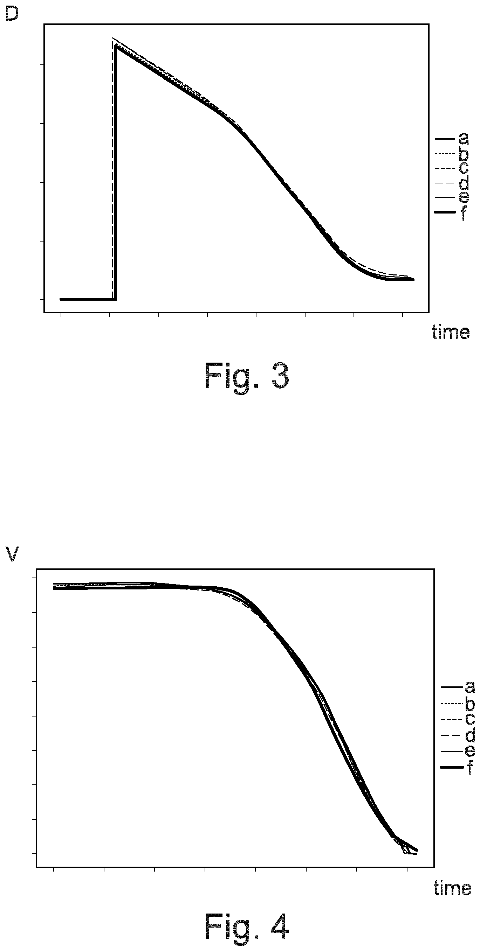

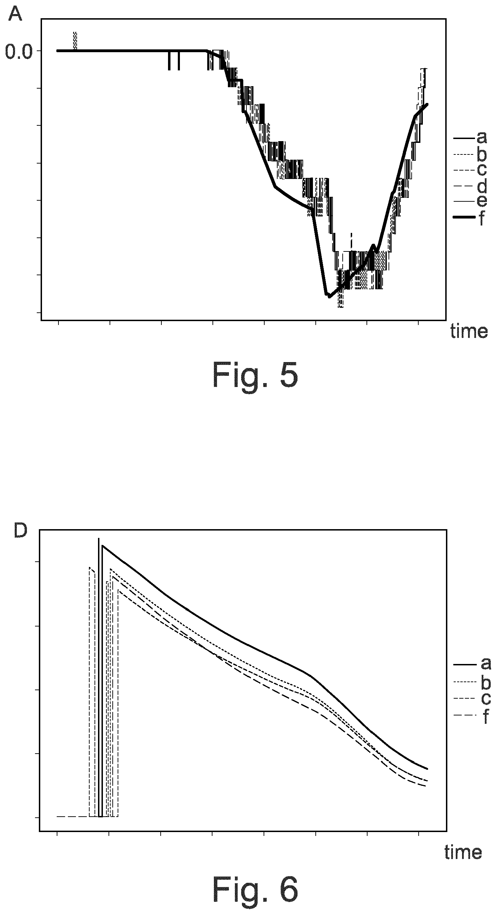

For each test run, the longitudinal distance D between the autonomous vehicle 20 and the other vehicle 26, the longitudinal speed V and the longitudinal acceleration A of the autonomous vehicle 20 are documented. Exemplary graphs showing the longitudinal distance D between the autonomous vehicle 20 and the other vehicle 26 over time for each of the five test runs are shown in Figure 3 (cf. graphs a, b, c, d and e). Exemplary graphs showing the longitudinal velocity V of the autonomous vehicle 20 over time for each of the five test runs are shown in Figure 4 (cf. graphs a, b, c, d and e). Exemplary graphs showing the longitudinal acceleration A of the autonomous vehicle 20 over time for each of the five test runs are shown in Figure 5 (cf. graphs a, b, c, d and e).

It is noted that the parameters of the cut-in scenario include the initial speeds of the autonomous vehicle 20 and the other vehicle 26, the distance between the autonomous vehicle and the other vehicle 26 when starting the lane change of the other vehicle 26, the duration for the lane change, the target deceleration and the curvature of the road.

Thus, different kinds of cut-in scenarios may be generated by varying one or more of these parameters.

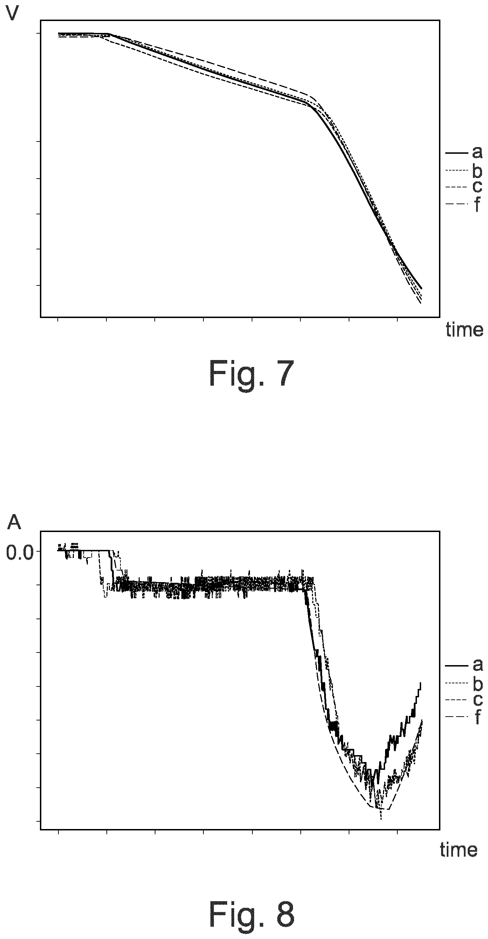

An outcome of a modified scenario is shown in Figures 6 to 8. In the modified scenario, three test runs have been performed. Exemplary graphs showing the longitudinal distance D between the autonomous vehicle 20 and the other vehicle 26 over time for each of the three test runs are shown in Figure 6 (cf. graphs a, b, and c). Exemplary graphs showing the longitudinal velocity V of the autonomous vehicle 20 over time for each of the three test runs are shown in Figure 7 (cf. graphs a, b, and c). Exemplary graphs showing the longitudinal acceleration A of the autonomous vehicle 20 over time for each of the three test runs are shown in Figure 8 (cf. graphs a, b, and c).

It is noted that instead of documenting the distance D between the autonomous vehicle 20 and the other vehicle 26, it is also possible to document the positions P1, P2 over time for each of the autonomous vehicle 20 and the other vehicle 26. Based thereon, the distance D over time may be calculated.

In order to execute the cut-in scenario in the first testing environment, i.e. on the physical test track, this scenario may be expressed in an OpenSCENARIO format and an OpenDRIVE format. Scenarios in these formats can be directly used by the autonomous vehicle 20 on the test track to perform the designated scenarios. Alternatively, known tools can convert the scenarios into different representations, e.g., tabulated values of distance on path, time, and x-, and y-coordinates, that are suitable for the software on the autonomous vehicle 20 for loading the scenarios.

After the executions of the test runs in the first testing environment, a first step S1 of the method for enabling validation may be executed.

The first step S1 comprises receiving first data indicative of a test of the control system 22 in the first testing environment. Thus, in the present example, the first data is indicative of the five test runs that have been performed in the first testing environment. In case the modified scenario is used, the first data is indicative of the three test runs of the modified scenario.

The first data is received at the data processing apparatus 10.

In more detail, the first data is indicative of a distance D between the autonomous vehicle 20 and the other vehicle 26 or obstacle, a longitudinal velocity V of the autonomous vehicle 20 and a longitudinal acceleration A of the autonomous vehicle 20.

Subsequently, a second step S2 of the method for enabling validation is executed.

In the second step S2, the second testing environment, i.e. the simulation, is modified or confirmed based on the first data. This is done in order to enhance comparability of the tests performed using the first testing environment and the second testing environment.

The second step S2 is executed using the data processing apparatus 10.

In the present example, the initial speeds of the autonomous vehicle 20 are averaged across the test runs executed in the first testing environment. Then, the average initial speed is used as a parameter in the second testing environment, i.e. in the simulation.

Additionally, the speed profiles of the autonomous vehicle 20 in the different test runs, i.e. the speed over time, executed in the first testing environment are averaged. Based thereon, an average speed profile is input to the second testing environment.

Now, a test run is executed using the second testing environment. Since in the present example, the second testing environment is of deterministic nature, a single test run is sufficient.

It is understood that due to the fact that the second testing environment is a virtual testing environment, this testing environment comprises a representation of the autonomous vehicle 20 and a representation of the other vehicle 26 or obstacle.

More generally speaking, the cut-in scenario is reproduced using the second testing environment. As has been explained before in connection with the first testing environment, a distance D between the representation of the autonomous vehicle 20 and the representation of the other vehicle 26, a longitudinal speed V of the representation of the autonomous vehicle 20, and a longitudinal acceleration A of the representation of the autonomous vehicle 20 are documented.

Corresponding graphs are provided in Figures 3 to 5 (cf. graph f). Also for the modified cut-in scenario, corresponding graphs are provided in Figures 6 to 8 (cf. graph f).

The documented distance D between the representation of the autonomous vehicle 20 and the representation of the other vehicle 26, the documented longitudinal speed V of the representation of the autonomous vehicle 20, and the documented longitudinal acceleration A of the representation of the autonomous vehicle 20 may be summarized as second data indicative of a test of the control system in the second testing environment.

Consequently, in a third step S3 of the method for enabling the validation, the second data is received. More precisely, the second data is received at the data processing apparatus 10.

Thereafter, in a fourth step S4, the first data and the second data are coordinated. In the present example, the first data and the second data are synchronized. To this end, the data processing unit 14 and the data storage unit 12 of the data processing apparatus 10 are used.

To this end, a first instance within the first data is determined, wherein at the first instance the autonomous vehicle 20 reacts to the other vehicle 26 or obstacle for the first time by adapting its driving. In an alternative, the first instance may be defined by the point in time at which the other vehicle 26 or obstacle enters the lane 24 of the autonomous vehicle 20.

Additionally, a second instance is determined within the second data at which the representation of the autonomous vehicle 20 reacts to the representation of the other vehicle 26 or obstacle for the first time. In an alternative corresponding to the above-mentioned alternative, the second instance corresponds to the point in time at which the representation of the other vehicle 26 or obstacle enters the lane 24 of the representation of the autonomous vehicle 20.

Based thereon, a synchronization point is selected prior to the first instance and prior to the second instance.

More precisely, the synchronization point is selected at an instance at which the first data is substantially constant and at which the second data is substantially constant. Since in the present example, both the first data and the second data comprise data on a distance D between the autonomous vehicle 20 and the other vehicle 26 or the corresponding representations, a synchronization criteria relates to a distance D between the autonomous vehicle 20 or the representation of the autonomous vehicle 20 and the obstacle 26 or the representation of the obstacle 26.

In other words, the first data and the second data are synchronized at a point where a distance D between the autonomous vehicle 20 and the other vehicle 26 as shown in the first data is the same as a distance D between the representation of the autonomous vehicle 20 and the representation of the other vehicle 26 as shown in the second data.

Moreover, synchronizing the first data and the second data comprises backwards extrapolating the first data and the second data.

Subsequently, in an optional fifth step S5, statistical characteristics of the first data and the second data may be obtained and compared. This may be done using the data processing unit 14 and the data storage unit 12 of the data processing apparatus 10. The statistical characteristics for example relate to averages or standard deviations characterizing the longitudinal velocity V of the autonomous vehicle 20 or the representation of the autonomous vehicle 20. In another example, the statistical characteristics relates to averages or standard deviations characterizing the longitudinal acceleration A of the autonomous vehicle 20 or the representation of the autonomous vehicle 20.

Comparing the statistical characteristic of the first data and the statistical characteristic of the second data allows to have a preliminary assessment on the similarity or comparability of the first testing environment that the second testing environment.

Thereafter, in a sixth step S6, a correlation of at least one element of the first data and at least one element of the second data is determined. To this end, the data processing unit 14 and the data storage unit 12 of the data processing apparatus 10 are used. More precisely, in the present example, a correlation of the element of the first data relating to the distance D between the autonomous vehicle 20 and the other vehicle 26 and the element of the second data relating to the distance D between the representation of the autonomous vehicle 20 and the representation of the other vehicle 26 is calculated.

Additionally, a correlation between the element of the first data relating to the longitudinal velocity V of the autonomous vehicle and the element of the second data relating to the longitudinal velocity V of the representation of the autonomous vehicle 20 is calculated

Furthermore, a correlation between the element of the first data relating to the longitudinal acceleration A of the autonomous vehicle 20 and the element of the second data relating to the longitudinal acceleration A of the representation of the autonomous vehicle 20 is calculated. Moreover, these correlations may be aggregated to an overall correlation.

In this context, the so-called Pearson correlation or linear correlation may be calculated.

In this case, a correlation of 0.7 to 1.0 indicates a high linear correlation. A correlation of 0.5 to 0.7 indicates a moderate linear correlation. A correlation of 0.3 to 0.5 indicates a low linear correlation. A correlation of 0.1 to 0.3 indicates a weak linear correlation. A correlation close to 0.0 indicates a very weak or no linear relationship.

Once the correlation is determined, the correlation may be compared to a correlation threshold.

If the determined correlation is above the correlation threshold, the first data and the second data are considered to be sufficiently related. In such a case, the first testing environment and the second testing environment are considered to provide comparable test results. In other words, the second testing environment may be considered to be valid with respect to the first testing environment and vice versa. Altogether, calculating the correlation enables the validation of the second testing environment against the first testing environment and vice versa.

According to an alternative, root means squared errors may be determined instead of the Pearson correlation. These errors may be expressed as percentages. Errors below 10% may be considered to be excellent. Errors between 10% and 20% may be considered to be good. Errors between 20% and 30% may be considered to be fair and errors above 30% may be considered to be poor. As before, an error threshold may be defined and the first data and the second data may be considered to be sufficiently related if the calculated error is below the error threshold.

Also using this alternative, the second testing environment may be validated against the first testing environment and vice versa.

As has been mentioned above, the cut-in scenario is just an example.

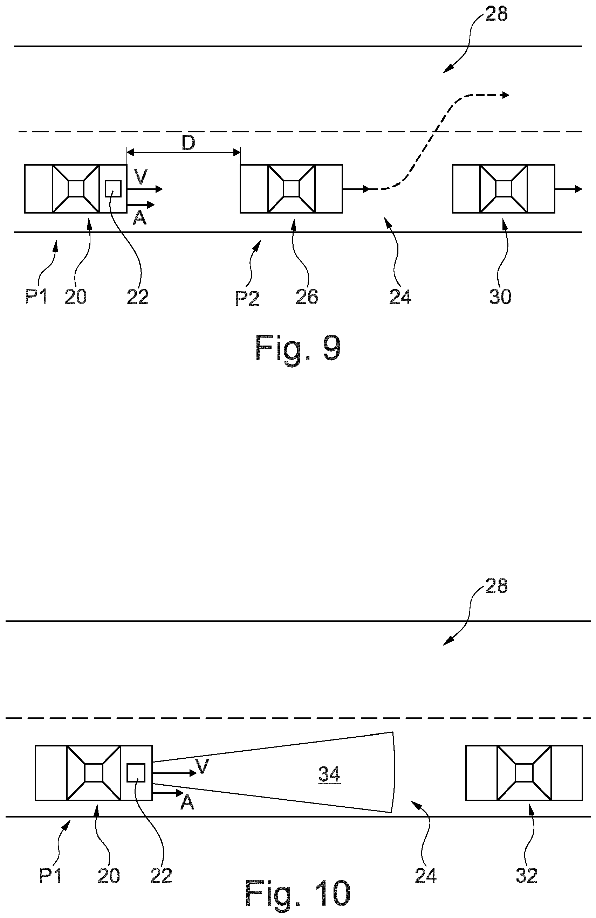

The method for enabling validation may also be used in connection with a so-called cut-out scenario. In the cut-out scenario the autonomous vehicle 20 and the other vehicle 26 are traveling in the same lane 24, wherein the other vehicle 26 is traveling in front of the autonomous vehicle 20. At the same time, the other vehicle 26 is occluding a further vehicle 30 or further obstacle. For this reason, the autonomous vehicle 20 cannot detect the further vehicle 30 or obstacle. At a given point in time, the other vehicle 26 leaves the lane and the autonomous vehicle needs to react to the further vehicle 30 or obstacle which then is not occluded anymore (cf. Figure 9). The above explanations apply mutatis mutandis to the cut-out scenario.

According to a further example, the method for enabling validation may be used in connection with a so-called stationary target scenario. In such a scenario, there is a stationary target 32 on the road. Initially, this stationary target 32 is not detected by the autonomous vehicle 20. However, upon further traveling along the road, the stationary target reaches the field of detection 34 of the autonomous vehicle 20 (cf. Figure 10). In the present example, the stationary target is a vehicle that has stopped on the road. The above explanations apply mutatis mutandis to the stationary target scenario.

As used herein, the phrase "at least one," in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that entities may optionally be present other than the entities specifically identified within the list of entities to which the phrase "at least one" refers, whether related or unrelated to those entities specifically identified. Thus, as a non-limiting example, "at least one of A and B" (or, equivalently, "at least one of A or B," or, equivalently "at least one of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. A computer program may be stored/distributed on a suitable medium such as an optical storage medium or a solid-state medium supplied together with or as part of other hardware, but may also be distributed in other forms, such as via the Internet or other wired or wireless telecommunication systems. Any reference signs in the claims should not be construed as limiting the scope of the claims.

### LIST OF REFERENCE SIGNS

- 10: data processing apparatus
- 12: data storage unit
- 14: data processing unit
- 16: computer-readable storage medium
- 18: computer program
- 19: means for carrying out the method for enabling validation
- 20: autonomous vehicle
- 22: control system
- 24: first lane
- 26: other vehicle, obstacle
- 28: second lane
- 30: further obstacle, further vehicle
- 32: stationary target
- 34: field of detection

- A: acceleration of the autonomous vehicle or the representation of the autonomous vehicle
- D: distance between the autonomous vehicle or the representation of the autonomous vehicle and the obstacle or the representation of the obstacle
- P1: position over time of the autonomous vehicle or the representation of the autonomous vehicle
- P2: position over time of the obstacle or the representation of the obstacle
- S 1: first step
- S2: second step
- S3: third step
- S4: fourth step
- S5: fifth step
- S6: sixth step
- V: velocity of the autonomous vehicle or the representation of the autonomous vehicle

## Claims

1. A method for enabling validation of a first testing environment configured for testing a control system (22) of an autonomous vehicle (20) against a second testing environment configured for testing the control system (22) of the autonomous vehicle (20), wherein each of the first testing environment and the second testing environment comprises the autonomous vehicle (20) or a representation of the autonomous vehicle (20) and an obstacle (26) or a representation of the obstacle (26), and wherein both the first testing environment and the second testing environment are associated with the same real-world scenario, the method comprising:
- receiving first data indicative of a test of the control system (22) in the first testing environment (S 1),
- receiving second data indicative of a test of the control system (22) in the second testing environment (S3),
- coordinating the first data and the second data (S4), and
- subsequently determining a correlation of at least one element of the first data and at least one element of the second data, thereby enabling validation (S6).

2. The method of claim 1, wherein at least one of the first testing environment and the second testing environment is of probabilistic nature and/or wherein at least one of the first testing environment and the second testing environment is of deterministic nature.

3. The method of claim 1 or 2, further comprising:
- modifying or confirming the first testing environment based on the second data, and/or
- modifying or confirming the second testing environment based on the first data (S2).

4. The method of any one of the preceding claims, further comprising:
- obtaining at least one statistical characteristic of the first data,
- obtaining at least one statistical characteristic of the second data, and
- comparing the at least one statistical characteristic of the first data and the at least one statistical characteristic of the second data (S5).

5. The method of any one of the preceding claims, wherein the first data is indicative of one or more of
- a position (P1) over time of the autonomous vehicle (20) or the representation of the autonomous vehicle (20),
- a position (P2) over time of the obstacle (26) or the representation of the obstacle (26),
- a distance (D) between the autonomous vehicle (20) or the representation of the autonomous vehicle (20) and the obstacle (26) or the representation of the obstacle (26),
- a velocity (V) of the autonomous vehicle (20) or the representation of the autonomous vehicle (20), or
- an acceleration (A) of the autonomous vehicle (20) or the representation of the autonomous vehicle (20), and/or
wherein the second data is indicative of one or more of
- a position (P1) over time of the autonomous vehicle (20) or the representation of the autonomous vehicle (20),
- a position (P2) over time of the obstacle (26) or the representation of the obstacle (26),
- a distance (D) between the autonomous vehicle (20) or the representation of the autonomous vehicle (20) and the obstacle (26) or the representation of the obstacle (26),
- a velocity (V) of the autonomous vehicle (20) or the representation of the autonomous vehicle (20), or
- an acceleration (A) of the autonomous vehicle (20) or the representation of the autonomous vehicle (20).

6. The method of any one of the preceding claims, wherein coordinating the first data and the second data comprises
- determining a first instance within the first data at which the autonomous vehicle (20) or the representation of the autonomous vehicle (20) reacts to the obstacle (26) or the representation of the obstacle (26) for the first time or at which the obstacle (26) or the representation of the obstacle (26) enters a lane (24) or at which the obstacle (26) or a representation of the obstacle (26) leaves a lane (24),
- determining a second instance within the second data at which the autonomous vehicle (20) or the representation of the autonomous vehicle (20) reacts to the obstacle (26) or to the representation of the obstacle (26) for the first time or at which the obstacle (26) or the representation of the obstacle (26) enters a lane (24) or at which the obstacle (26) or the representation of the obstacle (26) leaves a lane (24), and
- selecting a coordination point prior to the first instance and prior to the second instance.

7. The method of claim 6, wherein the coordination point is selected at an instance at which the first data is substantially constant and at which the second data is substantially constant.

8. The method of claim 5 and claim 6 or 7, wherein a coordination criteria relates to a distance (D) between the autonomous vehicle (20) or the representation of the autonomous vehicle (20) and the obstacle (26) or the representation of the obstacle (26).

9. The method of any one of the preceding claims, wherein coordinating the first data and the second data comprises backwards extrapolating the first data and the second data.

10. The method of any one of the preceding claims, wherein determining a correlation comprises determining a linear correlation and/or determining root means squared errors.

11. The method of any one of the preceding claims, wherein determining a correlation comprises determining a correlation measure and comparing the correlation measure to a threshold.

12. The method of any one of the preceding claims, wherein the at least one element of the first data and the at least one element of the second data is indicative of one or more of
- a distance (D) between the autonomous vehicle (20) or the representation of the autonomous vehicle (20) and the obstacle (26) or the representation of the obstacle (26),
- a velocity (V) of the autonomous vehicle (20) or the representation of the autonomous vehicle (20) or
- an acceleration (A) of the autonomous vehicle (20) or the representation of the autonomous vehicle (20).

13. A data processing apparatus (10) comprising means (19) for carrying out the method of any one of the preceding claims.

14. A computer program (18) comprising instructions which, when the computer program (18) is executed by a computer, cause the computer to carry out the method of claims 1 to 12.

15. A computer-readable storage medium (16) comprising instructions which, when executed by a computer, cause the computer to carry out the method of claims 1 to 12.

## Amended claims

### Amended claims in accordance with Rule 137(2) EPC.

1. A method for enabling validation of a first testing environment configured for testing a control system (22) of an autonomous vehicle (20) against a second testing environment configured for testing the control system (22) of the autonomous vehicle (20), wherein each of the first testing environment and the second testing environment comprises the autonomous vehicle (20) or a representation of the autonomous vehicle (20) and an obstacle (26) or a representation of the obstacle (26), and wherein both the first testing environment and the second testing environment are associated with the same real-world scenario, the method comprising:
- receiving first data indicative of a test of the control system (22) in the first testing environment (S1),
- receiving second data indicative of a test of the control system (22) in the second testing environment (S3),
- coordinating the first data and the second data (S4), wherein coordinating the first data and the second data comprises synchronizing the first data and the second data, and
- subsequently determining a correlation of at least one element of the first data and at least one element of the second data, thereby enabling validation (S6).

2. The method of claim 1, wherein at least one of the first testing environment and the second testing environment is of probabilistic nature and/or wherein at least one of the first testing environment and the second testing environment is of deterministic nature.

3. The method of claim 1 or 2, further comprising:
- modifying or confirming the first testing environment based on the second data, and/or
- modifying or confirming the second testing environment based on the first data (S2).

4. The method of any one of the preceding claims, further comprising:
- obtaining at least one statistical characteristic of the first data,
- obtaining at least one statistical characteristic of the second data, and
- comparing the at least one statistical characteristic of the first data and the at least one statistical characteristic of the second data (S5).

5. The method of any one of the preceding claims, wherein the first data is indicative of one or more of
- a position (P1) over time of the autonomous vehicle (20) or the representation of the autonomous vehicle (20),
- a position (P2) over time of the obstacle (26) or the representation of the obstacle (26),
- a distance (D) between the autonomous vehicle (20) or the representation of the autonomous vehicle (20) and the obstacle (26) or the representation of the obstacle (26),
- a velocity (V) of the autonomous vehicle (20) or the representation of the autonomous vehicle (20), or
- an acceleration (A) of the autonomous vehicle (20) or the representation of the autonomous vehicle (20), and/or
wherein the second data is indicative of one or more of
- a position (P1) over time of the autonomous vehicle (20) or the representation of the autonomous vehicle (20),
- a position (P2) over time of the obstacle (26) or the representation of the obstacle (26),
- a distance (D) between the autonomous vehicle (20) or the representation of the autonomous vehicle (20) and the obstacle (26) or the representation of the obstacle (26),
- a velocity (V) of the autonomous vehicle (20) or the representation of the autonomous vehicle (20), or
- an acceleration (A) of the autonomous vehicle (20) or the representation of the autonomous vehicle (20).

6. The method of any one of the preceding claims, wherein coordinating the first data and the second data comprises
- determining a first instance within the first data at which the autonomous vehicle (20) or the representation of the autonomous vehicle (20) reacts to the obstacle (26) or the representation of the obstacle (26) for the first time or at which the obstacle (26) or the representation of the obstacle (26) enters a lane (24) or at which the obstacle (26) or a representation of the obstacle (26) leaves a lane (24),
- determining a second instance within the second data at which the autonomous vehicle (20) or the representation of the autonomous vehicle (20) reacts to the obstacle (26) or to the representation of the obstacle (26) for the first time or at which the obstacle (26) or the representation of the obstacle (26) enters a lane (24) or at which the obstacle (26) or the representation of the obstacle (26) leaves a lane (24), and
- selecting a coordination point prior to the first instance and prior to the second instance.

7. The method of claim 6, wherein the coordination point is selected at an instance at which the first data is substantially constant and at which the second data is substantially constant.

8. The method of claim 5 and claim 6 or 7, wherein a coordination criteria relates to a distance (D) between the autonomous vehicle (20) or the representation of the autonomous vehicle (20) and the obstacle (26) or the representation of the obstacle (26).

9. The method of any one of the preceding claims, wherein coordinating the first data and the second data comprises backwards extrapolating the first data and the second data.

10. The method of any one of the preceding claims, wherein determining a correlation comprises determining a linear correlation and/or determining root means squared errors.

11. The method of any one of the preceding claims, wherein determining a correlation comprises determining a correlation measure and comparing the correlation measure to a threshold.

12. The method of any one of the preceding claims, wherein the at least one element of the first data and the at least one element of the second data is indicative of one or more of
- a distance (D) between the autonomous vehicle (20) or the representation of the autonomous vehicle (20) and the obstacle (26) or the representation of the obstacle (26),
- a velocity (V) of the autonomous vehicle (20) or the representation of the autonomous vehicle (20) or
- an acceleration (A) of the autonomous vehicle (20) or the representation of the autonomous vehicle (20).

13. A data processing apparatus (10) comprising means (19) for carrying out the method of any one of the preceding claims.

14. A computer program (18) comprising instructions which, when the computer program (18) is executed by a computer, cause the computer to carry out the method of claims 1 to 12.

15. A computer-readable storage medium (16) comprising instructions which, when executed by a computer, cause the computer to carry out the method of claims 1 to 12.
